(19) Europäisches Patentamt / European Patent Office / Office européen des brevets

(11) **EP 3 311 483 B1**

(12) **EUROPEAN PATENT SPECIFICATION**

(45) Date of publication and mention
of the grant of the patent:
**01.03.2023   Bulletin 2023/09**

(21) Application number: **16733245.1**

(22) Date of filing: **09.06.2016**

(51) International Patent Classification (IPC):
**H03F 1/30** *(2006.01)*      **H03F 3/19** *(2006.01)*
**H03F 3/193** *(2006.01)*     **H03F 3/195** *(2006.01)*
**H03F 3/72** *(2006.01)*

(52) Cooperative Patent Classification (CPC):
**H03F 3/195; H03F 1/303; H03F 3/193; H03F 3/72;**
H03F 2200/18; H03F 2200/27; H03F 2200/451;
H03F 2203/7203

(86) International application number:
**PCT/US2016/036546**

(87) International publication number:
**WO 2016/205049 (22.12.2016 Gazette 2016/51)**

(54) **BIAS CIRCUITRY FOR DEPLETION MODE AMPLIFIERS**

VORSPANNUNGSSCHALTUNG FÜR VERSTÄRKER VOM VERARMUNGSTYP

CIRCUITS DE POLARISATION POUR AMPLIFICATEURS EN MODE D'APPAUVRISSEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.06.2015   US 201562181713 P
07.06.2016   US 201615175610**

(43) Date of publication of application:
**25.04.2018   Bulletin 2018/17**

(60) Divisional application:
**22213788.7**

(73) Proprietor: **Raytheon Company
Waltham, MA 02451-1449 (US)**

(72) Inventors:
• **BETTENCOURT, John P.
Danvers, Massachusetts 01923 (US)**
• **BIELUNIS, Alan J.
Derry, NH 03038 (US)**
• **RODRIGUEZ, Istvan
Chelsea, Massachusetts 02150 (US)**
• **WANG, Zhaoyang C.
Carlisle, Massachusetts 01741-1055 (US)**

(74) Representative: **Carpmaels & Ransford LLP
One Southampton Row
London WC1B 5HA (GB)**

(56) References cited:
**EP-A1- 2 816 729      WO-A1-97/23037
WO-A1-98/38733      US-A1- 2010 039 168**

• **BONN F: "BIAS SCHEMES FOR ENHANCEMENT
AND DEPLETION MODE GAASFETS IN
SOURCE-FOLLOWER CONFIGURATION",
MOTOROLA TECHNICAL DEVELOPMENTS,
MOTOROLA INC. SCHAUMBURG, ILLINOIS, US,
vol. 18, 1 March 1993 (1993-03-01), pages 88-90,
XP000349571, ISSN: 0887-5286**

## Description

## TECHNICAL FIELD

This disclosure relates generally to bias circuitry and more particularly to bias circuitry for a wide bandgap high voltage depletion mode transistor within an RF amplifier.

## BACKGROUND

As is known in the art, RF power amplifiers using depletion mode transistors to amplify an input radio frequency signal often use solid state "drain" switches to turn on and off DC supply power.

An alternative to the drain switch is the gate switch, where a sufficiently negative voltage is supplied to the power amplifier's transistor gate to reduce the DC quiescent current to zero and also provide sufficient isolation in the RF path. An advantage of the gate switch approach is faster switching times between RF enable and off for systems using RF amplifiers. One such circuit (FIG. 1) is shown in US 6,600,301 B1, issued July 29, 2003, inventor DeFalco, assigned to the same assignee as the present invention. While such circuit has been found to be effective in many applications, in applications having a wide variation in temperature and power supply, a sufficient off-state voltage must be applied to it to establish proper quiescent bias for proper RF amplifier operation inclusive of process, temperature, and power supply variations.

As is also known in the art, wide bandgap transistors such as Gallium Nitride (GaN) High Electron Mobility Transistor (HEMT) and Silicon Carbide (SiC) Metal-Semiconductor Field Effect Transistor (MESFET) are great Radio Frequency (RF) power devices for their high voltage swings, high break voltages as well as the excellent thermal conductivity. Si Complimentary Silicon Oxide Semiconductor (CMOS) technologies offer tremendous levels of complexity and integration. Heterogeneous integration of both technologies can enable more features and capabilities of high performance microwave and mm Wave systems. However, wide bandgap transistors operate in the range of tens (10s) to hundreds (100s) volts, and the supply voltage of sub-micron Si CMOS circuit is normally under 2.5V. Providing a low voltage CMOS bias control circuits to a high voltage GaN transistor is a challenge. Previously, the attempt had been made to control GaN HEMT bias with Si pMOS, which is operated in high voltage supply, 14Volts as described in a paper by Kazior, T.E. ; Chelakara, R. ; Hoke, W. ; Bettencourt, J. ; Palacios, T. ; Lee, H.S. entitled "High Performance Mixed Signal and RF Circuits Enabled by the Direct Monolithic Heterogeneous Integration of GaN HEMTs and Si CMOS on a Silicon Substrate", Compound Semiconductor Integrated Circuit Symposium (CSICS), 2011 IEEE DOI: 10.1109/CSICS.2011.6062443, Page(s): 1 - 4.

WO 97/23037 A1 relates to a power amplifier operating with a signal power supply. The amplifier includes at least one depletion-mode FET for amplifying an A/C signal and a negative voltage generator for providing a bias to the FET. The generator includes a multivibrator for producing two clock signals and a charge pump which receives the clock signals and produces a negative voltage. The negative voltage is provided as a low reference potential to the multivibrator so that the clock signals it produced include a negative voltage period, which enables the charge pump to operate in a power efficient manner.

US 2010/039168 A1 relates to a network having a current mirror comprising: a output transistor having a gate electrode for controlling a first current between a first electrode and a second electrode, the first electrode being coupled to a positive reference potential and the second electrode being connected to ground. A second transistor has a gate electrode for controlling a second current between a first electrode and a second electrode of the second transistor. The gate electrodes are connected together to produce the first current and the second current with equal current densities. A first portion of current from a current source is fed to the first electrode of the second transistor and a second portion of current from the current source is fed to a bias voltage producing circuit producing a bias voltage at the gate electrode of the output transistor for tracking variations in the first current passing through the output transistor.

EP 2 816 729 A1 relates to a half-bridge or multiple half-bridge switch configuration used in a voltage converter circuit using at least two normally ON switches. Such a circuit includes a high side switch and a low side switch coupled between a high voltage rail and a low voltage rail of the voltage converter circuit. The high side switch is coupled to the low side switch at a switch node of the voltage converter circuit. At least one group IV enhancement mode switch is used as an enable switch. The group IV enhancement mode enable switch may be an insulated gate bipolar transistor, IGBT, a super-junction field-effect transistor, SJFET, a unipolar group IV field-effect transistor, FET, or a bipolar junction transistor, BJT.

Flexible current control in power amplifiers is known from WO9838733A1. Therein is disclosed a wireless communications system having a plurality of portable devices in communication therewith, said portable devices including a transmitter circuit therein, circuitry within a given one of said portable devices for adjustably controlling current levels to said transmitter circuit therein, said circuitry comprising a digital-to-analog converter for converting a digital input signal to an analog signal corresponding thereto, said converter producing a multiplicity of discrete analog signals adjustably controlled by said digital input signal, and a mirror circuit, connected to said converter, for receiving said discrete analog signal therefrom and forwarding an adjusted analog signal to said transmitter circuit.

## SUMMARY

In accordance with the invention, a circuit is provided as defined by independent claim 1 and dependent claim 2.

## DESCRIPTION OF DRAWINGS

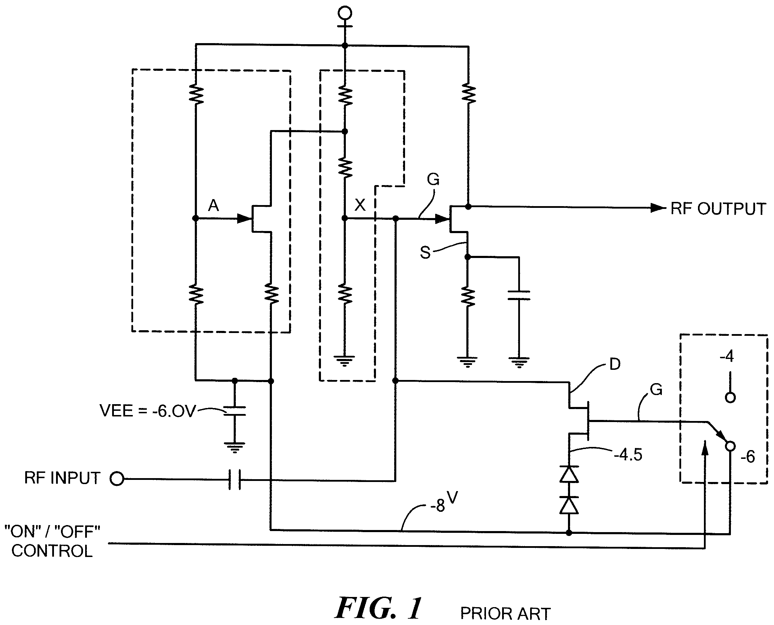

FIG. 1 is a circuit according to the PRIOR ART:

FIG. 2 is a circuit according to an embodiment of the disclosure according to the claimed invention; and

FIG. 3 shows the implementation of a control circuit used in the circuit of FIG. 2.

Like reference symbols in the various drawings indicate like elements.

## DETAILED DESCRIPTION

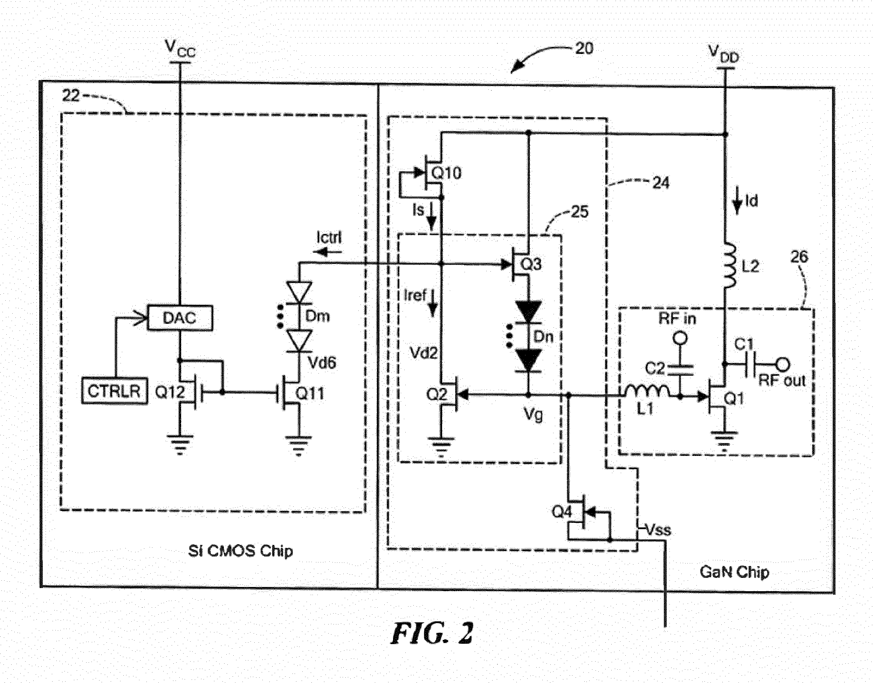

Referring now to FIG. 2, a circuit 20 is shown having an RF amplifier 26 comprising: a depletion mode transistor Q1 having a source electrode coupled to a reference potential, here ground; a drain electrode coupled to a potential more positive than the reference potential, here $V_{DD}$ through an inductor L2, as shown, and a gate electrode for coupling to an input signal, here an RF input through a capacitor, C2, as shown. It is noted that the source electrode of the transistor Q1 is connected to a reference potential, here ground, as shown. The circuit 20 is shown here having further a bias circuit 24 comprising a current source Q10 and biasing circuitry 25 coupled to the current source Q10 and between the potential more positive than the reference potential, here $V_{DD}$, and a potential more negative than the reference potential, here - $V_{SS}$; and a control circuit 22 that varies the amount of current, Ictrl, diverted from the current source Q10 to biasing circuitry 25 selectively in accordance with a control signal fed to the control circuit to corresponding vary a bias voltage Vg fed by an output of the biasing circuitry 25 through an inductor L1 at the gate electrode of the depletion mode transistor, Q1. Here, FIG. 2 the control circuit 22 controls the bias circuit 24 being a GaN HEMT bias circuit formed on a Group III-V chip, here a GaN chip, using submicron Silicon (Si) CMOS current Digital to Analog Converter (DAC) formed on a silicon chip. Thus, the bias circuit 24 on the right is in GaN HEMT technology, that is formed using a GaN chip. It is a D-mode current mirror circuit for Quiescent bias control of GaN RF amplifier 26. Depletion mode transistor Q10 provides a constant current source, Is. Depletion mode transistor Q2 is a GaN mirror FET and depletion mode transistor Q1 is a GaN HEMT used in the RF amplifier 26. The reference current Is drawn in to transistor Q2 and controls the quiescent current Id of transistor Q1. For the mirror circuit works properly, transistor Q2 needs to be in saturation mode. For a typical GaN HEMT, the drain voltage of transistor Q2, voltage Vd2 should be about 5V or higher. Vd2 is set by transistor Q3 and a series of a plurality n of diodes GaN diodes Dn, where n is the number of diodes in the series selected in accordance with the voltages used, here for example, Vdd is 24 volts and -Vss is -8.0 volts. The voltage drop across each of the n diodes Dn is set by current source of Q11 which, as will be shown, is controlled by a control signal CNTLR fed to a Digital to Analog Converter (DAC). The source of the control signal may be, for example, an analog signal related to the temperature of the GaN chip. Thus, the amount of current Ictrl passing though the diodes Dm, that is the amount of current bled from the current source Q10, Is, is a function of the control signal CNTLR fed to the DAC.

More particularly, the circuit 22 on the left in FIG. 2 is in a submicron Si CMOS technology that is formed on a silicon chip. The control current 22 controls the amount of current Ictrl bled or drawn from the current source Is. Thus, the control signal CTRLR diverts current Is produced by the current source, transistor Q10, from the biasing circuit in accordance with the control signal.

Assuming the gate current of transistor Q3 can be neglected in this analysis, the reference current is

$$Iref = Is - Ictrl \quad (1)$$

where Iref is the amount of current produced by the current source Q10 and fed to the biasing circuitry 25, here interconnected transistors Q2, Q3 and diodes Dn and Ictrl is the amount of current produced by the current source Q10 and diverted to the control circuit 22, more particularly diodes Dm and transistor Q11. Thus, by using this current diversion process rather that a current injection process, the control circuit 22 is able to be implemented with relatively low voltage supplies, Vcc.

In the CMOS control circuit 22, Ictrl is thus controlled by a standard current CMOS Digital to Analog Converter (DAC) coupled between Vcc and current mirror made up of diode connected NMOS transistor Q12 and NMOS transistor Q11, connected as shown. The CMOS circuit 22 is supplied by the standard CMOS supply voltage, Vcc, usually 2.5V or less. For deep submicron CMOS technology, the supply voltage can be 1.5V or lower. To keep the NMOS FET Q11 in a safe operational voltage range, a series of Si diodes Dm is used to connect the drain of NMOS FET Q11 to the drain of GaN HEMT Q2. The Si diodes Dm can be easily formed using NMOS FET or lateral PNP transistor offered in standard CMOS process. These diodes Dm lower the voltage of Vd2 (~>5V) to the safe drain voltage of Vd6, typically above 0.5V and less than 3V, depending on the CMOS technology used.

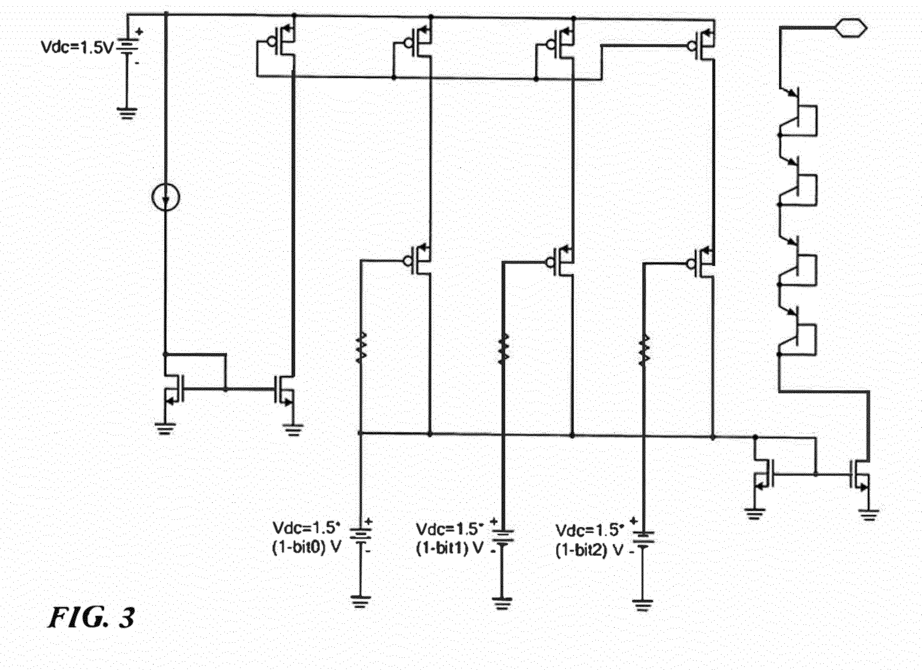

FIG. 3 shows the implementation of a control circuit on a 0.13um Si CMOS process. The output current is controlled by a current DAC supplied by 1.5V. Here, lateral PNP or VPNP transistors are used to form Si diodes Dm to level shift the output voltage.

Thus, the circuit shown in FIG. 2 has the following features:

1. Controlling the bias of wide bandgap high voltage transistor (such as GaN or SiC HEMTs) with standard submicron Si CMOS circuit
2. To control the reference current in GaN bias, CMOS current DAC is used to drain current from GaN current source.
3. A series of Si diodes and a series of GaN diodes are used to set the safe and proper operation voltages for NMOS current sourcing FET and GaN HEMT mirror FET
4. Direct integration of the CMOS and GaN circuit without interface or adaptor circuitry
5. Heterogeneous integration of item 1, 2 and 3.

An embodiment of the disclosure has been described. Nevertheless, it will be understood that various modifications may be made without departing from the scope of the invention as defined by the following claims.

## Claims

1. A circuit (20), comprising:

an RF amplifier (26), comprising:
a wide bandgap high voltage depletion mode transistor (Q1) having a source electrode coupled to a reference potential; a drain electrode coupled to a potential ($V_{DD}$) more positive than the reference potential; and a gate electrode for coupling to an input signal;
a bias circuit (24), comprising:
a current source (Q10); and biasing circuitry (25) coupled to the current source (Q10) and between the potential ($V_{DD}$) more positive than the reference potential and a potential ($-V_{SS}$) more negative than the reference potential; and
a CMOS control circuit (22) connected to the current source (Q10) for controlling the amount of current produced by the current source (Q10) to the biasing circuitry (25);
wherein the CMOS control circuit (22) includes a digital to analogue converter for varying the amount of current passing from the current source (Q10) to the biasing circuitry (25) in accordance with a control signal (CTRLR) fed to the digital to analogue converter to correspondingly vary a bias voltage (Vg) fed by an output of the biasing circuitry (25) through an inductor (L1) at the gate electrode of the wide bandgap high voltage depletion mode transistor (Q1), wherein the control signal diverts current (Ictrl) produced by the current source (Q10) from the biasing circuitry (25) in accordance with the control signal (CTRLR); and
wherein the RF amplifier (26) and bias circuit (24) are formed on a Group III-V chip and wherein the CMOS control circuit (22) is formed on a silicon chip.

2. The circuit recited in claim 1 wherein the biasing circuitry (25) comprises a plurality of additional depletion mode field effect transistors (Q2, Q3).

## Patentansprüche

1. Schaltung (20), die Folgendes umfasst:

einen HF-Verstärker (26), der Folgendes umfasst:

einen Hochspannungsverarmungsmodus-Transistor (Q1) mit breiter Bandlücke, der eine mit einem Referenzpotenzial gekoppelte Source-Elektrode; eine mit einem Potenzial ($V_{DD}$), das positiver als das Referenzpotenzial ist, gekoppelte Drain-Elektrode; und eine Gate-Elektrode zum Koppeln eines Eingangssignals aufweist;
eine Vorspannungsschaltung (24), die Folgendes umfasst:

eine Stromquelle (Q10); und
eine Vorspannungsschaltungsanordnung (25), die mit der Stromquelle (Q10) und zwischen dem Potenzial ($V_{DD}$), das positiver als das Referenzpotenzial ist, und einem Potenzial ($-V_{SS}$), das negativer als das Referenzpotenzial ist, gekoppelt ist; und

eine mit der Stromquelle verbunden (Q10)CMOS-Steuerschaltung (22) zum Steuern der durch die Stromquelle (Q10) produzierten Strommenge zu der Vorspannungsschaltungsanordnung (25);

wobei die CMOS-Steuerschaltung (22) einen Digital-Analog-Wandler beinhaltet zum Variieren der von der Stromquelle (Q10) zu der Vorspannungsschaltungsanordnung (25) geleiteten Strommenge gemäß einem dem Digital-Analog-Wandler zugeführten Steuersignal (CTRLR), um dementsprechend eine durch einen Ausgang der Vorspannungsschaltungsanordnung (25) über eine Induktivität (L1) an der Gate-Elektrode des Hochspannungsverarmungsmodus-Transistors (Q1) mit breiter Bandlücke zugeführte Vorspannung (Vg) zu variieren,

wobei das Steuersignal einen durch die Stromquelle (Q10) erzeugten Strom (Ictrl) gemäß dem Steuersignal (CTRLR) von der Vorspannungsschaltungsanordnung (25) umleitet; und

wobei der HF-Verstärker (26) und die Vorspannungsschaltung (24) auf einem Gruppe-III-V-Chip ausgebildet sind und wobei die CMOS-Steuerschaltung (22) auf einem Siliziumchip ausgebildet ist.

2. Schaltung nach Anspruch 1, wobei die Vorspannungsschaltungsanordnung (25) mehrere zusätzliche Verarmungsmodus-Feldeffekttransistoren (Q2, Q3) umfasst.

**Revendications**

1. Circuit (20), comprenant :

un amplificateur RF (26), comprenant :
un transistor (Q1) à mode de déplétion haute tension à large bande interdite ayant une électrode de source couplée à un potentiel de référence ; une électrode de drain couplée à un potentiel ($V_{DD}$) plus positif que le potentiel de référence ; et une électrode de grille pour se coupler à un signal d'entrée ;
un circuit de polarisation (24), comprenant :

une source de courant (Q10) ; et
des circuits de polarisation (25) couplés à la source de courant (Q10) et entre le potentiel ($V_{DD}$) plus positif que le potentiel de référence et un potentiel ($-V_{SS}$) plus négatif que le potentiel de référence ; et

un circuit de commande à CMOS (22) connecté à la source de courant (Q10) pour commander la quantité de courant produite par la source de courant (Q10) aux circuits de polarisation (25) ;
le circuit de commande à CMOS (22) comportant un convertisseur numérique-analogique pour faire varier la quantité de courant passant de la source de courant (Q10) aux circuits de polarisation (25) en fonction d'un signal de commande (CTRLR) fourni au convertisseur numérique-analogique pour faire varier en correspondance une tension de polarisation (Vg) fournie par une sortie des circuits de polarisation (25) via une bobine d'inductance (L1) au niveau de l'électrode de grille du transistor (Q1) à mode de déplétion haute tension à large bande interdite,
le signal de commande déviant le courant (Ictrl) produit par la source de courant (Q10) depuis les circuits de polarisation (25) en fonction du signal de commande (CTRLR) ; et
l'amplificateur RF (26) et le circuit de polarisation (24) étant formés sur une puce de groupe III-V et le circuit de commande à CMOS (22) étant formé sur une puce en silice.

2. Circuit selon la revendication 1, les circuits de polarisation (25) comprenant une pluralité de transistors (Q2, Q3) à effet de champ à mode de déplétion additionnels.

*FIG. 1*   PRIOR ART

FIG. 2

*FIG. 3*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6600301 B1
- WO 9723037 A1
- US 2010039168 A1
- EP 2816729 A1
- WO 9838733 A1

### Non-patent literature cited in the description

- High Performance Mixed Signal and RF Circuits Enabled by the Direct Monolithic Heterogeneous Integration of GaN HEMTs and Si CMOS on a Silicon Substrate. **KAZIOR, T.E. ; CHELAKARA, R. ; HOKE, W. ; BETTENCOURT, J. ; PALACIOS, T. ; LEE, H.S.** Compound Semiconductor Integrated Circuit Symposium (CSICS). IEEE, 2011, 1-4